# FASCICULE DE BREVET EUROPEEN

(11) **EP 4 019 459 B1**
(45) Date de publication et mention de la délivrance du brevet: **11.06.2025**
(21) Numéro de dépôt: 20217299.5
(22) Date de dépôt: 24.12.2020
(51) Int. Cl.: B81B 3/00, B81C 1/00, G04B 17/06, G04B 17/22, C22C 27/02

(54) **PROCÉDÉ DE FABRICATION D'UN RESSORT SPIRAL THERMOCOMPENSÉ**
VERFAHREN ZUR HERSTELLUNG EINER THERMOKOMPENSIERTEN SPIRALFEDER
METHOD FOR MANUFACTURING A THERMOCOMPENSATED HAIRSPRING

(43) Date de publication de la demande: 29.06.2022
(73) Titulaire: Atokalpa, succursale de Alle de SFF Composants Horlogers S.A., 2942 Alle (CH)
(72) Inventeur: JEANNERET, Sébastien, 2340 Le Noirmont (CH); GOLAY, Nicolas, 2000 Neuchâtel (CH)
(74) Mandataire: Patentsmith SA

(56) Documents cités:
- EP-A1- 1 039 352
- EP-A1- 3 502 785
- GROUPE DES FABRICANTS SUISSES DE SPIRAUX: "Le Spiral. Ses proprietes ses qualites sa manipulation", CLASSEUR TECHNIQUE A L'USAGE DU PRATICIEN, 1 January 1969 (1969-01-01), XP055654217

## Description

### Domaine technique

La présente invention se rapporte au domaine de l'horlogerie. Elle concerne, plus particulièrement, un ressort spiral thermocompensé pour oscillateur balancier-spiral.

### Etat de la technique

Le document EP3422116 décrit un procédé de fabrication d'un ressort spiral thermocompensé en alliage Niobium-Titane qui nécessite, non seulement une mise en forme, mais aussi plusieurs étapes de déformation et de traitement thermique, jusqu'à ce qu'une structure particulière de l'alliage soit atteinte. Ce faisant, le titulaire prétend obtenir un coefficient thermique du module de Young (CTE), c'est-à-dire une variation du module de Young en fonction de la température de +/- 10 ppm/°C, qui convient à l'utilisation d'un tel spiral avec un balancier en CuBe ou en maillechort afin de former un oscillateur balancier-spiral qui est peu ou pas susceptible à des variations de température dans la plage typique d'utilisation d'une montre-bracelet (c'est-à-dire de 0°C à 50°C).

Cependant, ce procédé est onéreux à mettre en œuvre au vu du nombre d'étapes nécessaires, et le document ne contient pas suffisamment d'informations sur les étapes de déformation et de traitement thermique nécessaires pour obtenir la structure cristallographique et ainsi les propriétés recherchées.

Le but de l'invention est par conséquent de proposer une pièce d'horlogerie dans laquelle les défauts susmentionnés sont au moins partiellement surmontés. La publication GROUPE DES FABRICANTS SUISSES DE SPIRAUX: "Le Spiral. Ses proprietes ses qualites sa manipulation", CLASSEUR TECHNIQUE A L'USAGE DU PRATICIEN, 1 janvier 1969 (1969-01-01), décrit les étapes principales de la fabrication d'un ressort spiral.

### Divulguation de l'invention

De façon plus précise, l'invention concerne un procédé de fabrication d'un ressort spiral pour oscillateur balancier-spiral, comme défini par la revendication 1. Ce procédé comporte les étapes de :
a) se munir d'une lame en alliage Niobium-Titane, Niobium-Zirconium ou Niobium-Hafnium présentant une hauteur et une épaisseur prédéterminées ;
b) effectuer un estrapadage de ladite lame afin de mettre ladite lame en forme de spiral ;
c) effectuer un traitement thermique de fixation afin de figer la forme de ladite lame qu'elle a pris lors de l'estrapadage ;
d) effectuer une oxydation de la surface de ladite lame jusqu'à une profondeur prédéterminée par exemple par oxydation thermique, anodisation ou similaire.

Ces étapes ne sont pas exclusives, et d'autres étapes peuvent bien entendu être effectuées avant, après ou entre les étapes précisées ci-dessus.

Selon l'invention, lesdites étapes sont effectuées selon la suite a), puis d), puis b), puis c), l'oxydation de la surface étant effectué avant la mise en forme du spiral par estrapadage et fixation thermique. La présence d'étapes supplémentaires intercalées entre les étapes a), d), b) et c) n'est pas exclue.

Ce procédé est très facile à mettre en œuvre par l'intermédiaire d'outils et d'appareils conventionnels, et permet d'obtenir un ressort spiral dont le CTE peut être proche de zéro (ou bien substantiellement zéro) et peut être varié en modifiant le taux d'oxydation effectué dans l'étape d).

Avantageusement, ladite lame est obtenue par laminage d'un fil tréfilé dudit alliage, une étape de coupe des lacets étant effectuée avant l'étape d) ou entre l'étape d) et l'étape b).

Avantageusement, l'étape d) est effectuée par oxydation thermique, en chauffant ladite lame sous les conditions suivantes :
- température entre 350°C et 700°C, de préférence entre 400°C et 600°C, encore de préférence entre 400°C et 450°C ;
- sous atmosphère oxydante (tel que l'air) à une pression entre 10⁻⁴ mbar à 10⁻² mbar, de préférence entre 10^{-3.5} mbar et 10^{-2.5} mbar et/ou à une pression partielle d'oxygène entre 0,2x10⁻⁴ mbar et 0,2x10⁻² mbar, de préférence entre 0,2x10^{-3.5} mbar and 0,2x10^{-2.5} mbar, ce qui est substantiellement équivalent à de l'air aux pressions susmentionnées (comme par exemple un mélange d'oxygène avec un gaz inerte à une pression ad hoc) ;
- durée comprise entre 1h et 20h, de préférence entre 2h et 14h.

De préférence, ladite atmosphère oxydante est de l'air ou de l'oxygène (éventuellement en combinaison avec un gaz inerte comme l'argon), et ledit chauffage peut être effectué de manière conventionnelle dans un four ou alternativement par l'effet Joule en passant un courant électrique le long de la lame afin d'obtenir une température de surface appropriée. Alternativement, l'oxydation peut être effectuée par une anodisation de la lame.

Avantageusement, ledit traitement thermique de fixation est effectué sous les conditions suivantes :
- pression entre 10⁻⁹ mbar et 10⁻⁵ mbar, de préférence entre 10⁻⁷ mbar et 10⁻⁶ mbar, et/ou sous atmosphère inerte ;
- température entre 400°C et 700°C ;
- durée entre 1h et 6h.

Avantageusement, ledit alliage est un alliage binaire Niobium-Titane présentant entre 40% et 60% par poids de titane, de préférence entre 45% et 55% par poids de titane, encore de préférence entre 46% et 48% par poids de titane.

### Brève description des dessins

D'autres détails de l'invention apparaîtront plus clairement à la lecture de la description qui suit, faite en référence aux dessins annexés dans lesquels :
- Fig. 1a à 1c sont des diagrammes schématiques de trois variantes d'un procédé de fabrication, dont celui de la fig. 1a est un exemple ne faisant pas partie de l'invention, et ceux des fig. 1b et 1c sont selon l'invention ;
- Fig. 2 est une vue partielle schématique en coupe d'un ressort spiral produit par un procédé selon l'invention, et ;
- Fig. 3 et 4 sont des graphiques illustrant le résultat d'essais effectués sur des spiraux fabriqués par le procédé selon l'invention, le taux d'oxydation de la surface ayant été varié par des températures de traitement thermique différentes.

### Modes de réalisation de l'invention

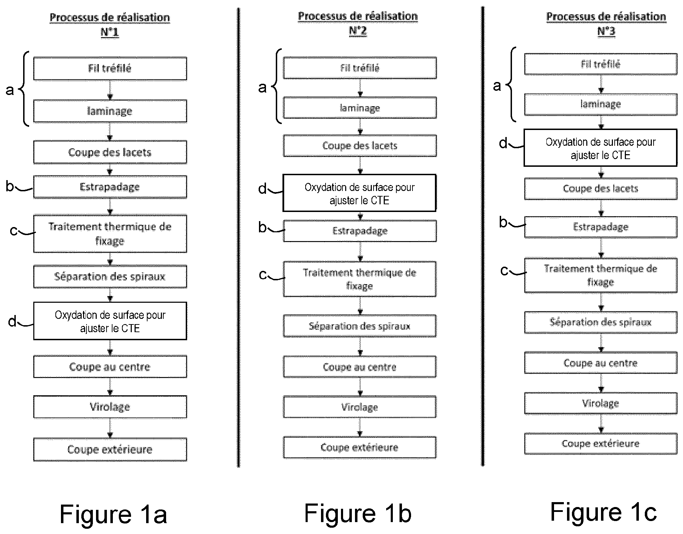

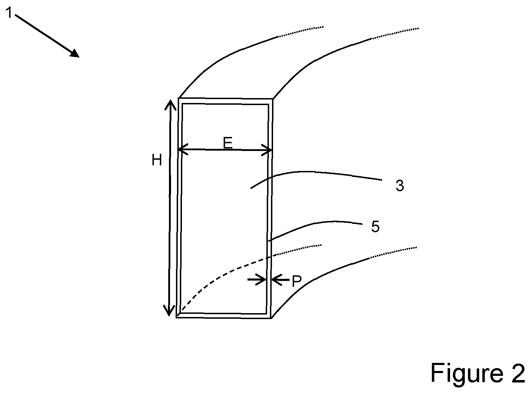

Les figures 1a à 1c illustrent schématiquement trois variantes d'un procédé de fabrication d'un ressort spiral 1 pour oscillateur balancier-spiral horloger, dont une partie en coupe est illustrée schématiquement sur la figure 2. La forme du spiral 1 n'est pas importante, et toute forme connue à l'homme du métier peut être utilisée. Comme généralement connu, l'une des extrémités du ressort spiral 1 (typiquement son extrémité intérieure) est destinée à être rendue solidaire en rotation d'un balancier de forme quelconque agencé pour effectuer des oscillations autour d'un axe de rotation et d'être entretenu par un mécanisme d'échappement soumis à une force motrice typiquement fournie par un ressort moteur logé dans un barillet et en liaison cinématique avec l'échappement par l'intermédiaire d'un rouage de finissage.

Les procédés illustrés sur les figures 1a à 1c présument que le fabricant reçoit la matière de base en forme de fil tréfilé puis effectue un laminage lui-même afin d'obtenir une lame 3 en matériau métallique ayant une épaisseur E (dans le plan du spiral 1), une hauteur H (perpendiculaire au plan du spiral 1) et une longueur L prédéterminées afin que le spiral 1 convient à l'application prévue. Cependant, il est possible que le fabricant se munisse d'une lame 3 déjà laminée et prête à être utilisée. Typiquement, l'épaisseur E est comprise entre 0,02 mm et 0,07 mm, la hauteur H est comprise entre 0,1 mm et 0,3 mm, tandis que la longueur L est comprise entre 50 mm et 250 mm.

Le matériau de la lame est soit un alliage Niobium-Titane (NbTi), soit un alliage Niobium-Zirconium (NbZr) ou soit un alliage Niobium-Hafnium (NbHf), de préférence binaire avec un taux d'impuretés inférieur à 0.3% en masse. Ces impuretés peuvent comporter, par exemple, O, H, C, Fe, Ta, N, Ni, Si, Cu et AI.

Si l'alliage est en NbTi, il peut comporter de préférence entre 40% et 60% par poids de titane, de préférence entre 45% et 55% par poids de titane ou encore de préférence entre 46% et 48%, la balance (à l'exception des éventuelles impuretés) étant en niobium. En effet, l'alliage NbTi47, comprenant substantiellement 47% par poids de titane, et qui est l'alliage le plus communément utilisé dans le commerce pour des supraconducteurs et est donc disponible sur le marché sous forme de fil présentant divers diamètres convenables à des ressorts spiraux 1.

Le laminage d'un fil métallique afin d'obtenir une lame telle que mentionnée ci-dessus est bien connu à l'homme du métier et ne doit donc pas être décrit en détail. Le procédé de laminage résulte en la présence de lacets aux extrémités de la lame ainsi obtenue, qui sont coupés à un moment convenable, comme découlera par la suite.

Le fabricant s'étant maintenant muni d'une lame présentant des dimensions souhaitées (étape a), il convient d'effectuer un estrapadage (étape b), un traitement thermique de fixage pour figer la forme du spiral 1 (étape c) ainsi qu'un traitement d'oxydation pour modifier le CTE du spiral 1 (étape d), qui influence également son module de Young.

Ces quatre étapes peuvent s'effectuer selon plusieurs suites, comme illustrées sur les figures 1a à 1c.

Dans le procédé de la figure 1a, après laminage et la coupe des lacets, la lame 3 est estrapadée dans un barillet de manière conventionnelle, et est ensuite recuite dans un four afin de figer la forme du spiral 1 (étape c). Ce procédé de traitement thermique de fixation est effectué par exemple, sous les conditions suivantes :
- pression entre 10⁻⁹ mbar et 10⁻⁵ mbar, de préférence entre 10⁻⁷ mbar et 10⁻⁶ mbar, et/ou sous atmosphère inerte ;
- température entre 400°C et 700°C (typiquement aux alentours de 600°C);
- durée entre 1h et 6h.

Si cette étape de procédé est effectuée en vidant de l'air ambiante d'un four sous vide, la pression partielle d'oxygène y présent est insuffisante pour oxyder la surface de la lame 3.

Puis, le spiral 1, ainsi figé, est séparé du barillet utilisé lors de l'estrapadage et pendant le traitement thermique de fixation, et est assujetti à un traitement d'oxydation de sa surface (étape d).

Ce traitement d'oxydation peut être effectué par n'importe quelle voie connue, par exemple une anodisation ou par une oxydation thermique sous atmosphère oxydante. Cette dernière possibilité privilégiée de toutes les autres, peut être effectuée en chauffant le spiral 1 dans un four sous les conditions suivantes :
- température entre 350°C et 700°C, de préférence entre 400°C et 600°C, encore de préférence entre 400°C et 450°C ;
- sous atmosphère oxydante, notamment l'air, à une pression entre 10⁻⁴ mbar à 10⁻² mbar, de préférence entre 10^{-3.5} mbar et 10^{-2.5} mbar ;
- durée comprise entre 1h et 20h, de préférence entre 2h et 14h.

Alternativement, le chauffage peut être effectué par l'effet Joule, en passant un courant le long de la lame 3 formant le spiral 1 de telle sorte que la température souhaitée à sa surface soit atteinte. Pour le surplus, au lieu d'une pression réduite d'air, il est également possible de prévoir une pression partielle d'oxygène équivalente dans un gaz inerte (tel que l'argon) à une pression quelconque (comme par exemple à pression ambiante), par exemple en prévoyant un mélange d'oxygène dans un gaz inerte dont la composition est choisie pour prévoir une pression partielle d'oxygène entre 0,2x10⁻⁴ mbar et 0,2x10⁻² mbar, de préférence entre 0,2x10^{-3.5} mbar and 0,2x10^{-2.5} mbar, ce qui est équivalent à de l'air aux pressions susmentionnées.

Ce faisant, la surface du spiral 1 est oxydée jusqu'à une profondeur de plusieurs dizaines de nm, qui est significativement supérieure à celle d'une éventuelle oxydation naturelle sous conditions ambiantes.

Finalement, le spiral 1 est coupé à son centre, virolé et puis coupé à son extérieur afin de terminer sa fabrication.

Les figures 1b et 1c illustrent des différentes suites d'étapes pour la fabrication d'un ressort spiral 1, selon l'invention.

Dans le procédé de la figure 1b, l'étape d'oxydation de la surface du spiral 1 (étape d) s'effectue après la coupe des lacets et avant l'étape d'estrapadage (étape b). En effet, il est possible d'effectuer l'étape d'estrapadage (étape b) lorsque la surface du spiral 1 est déjà oxydée, le traitement thermique de fixage (étape c) n'ayant aucune influence sur l'oxydation de la surface du spiral 1.

Le procédé de la figure 1c diffère de celui de la figure 1b en ce que l'étape d'oxydation de la surface du spiral 1 (étape d) s'effectue avant la coupe des lacets.

Dans chacun des procédés des figures 1b et 1c, l'étape d'oxydation de la surface du spiral 1 s'effectue par conséquent sur la lame 3 non enroulée, qui évite tout risque de déformation du spiral lors de l'étape d'oxydation (étape d), sa mise en forme étant effectuée après oxydation.

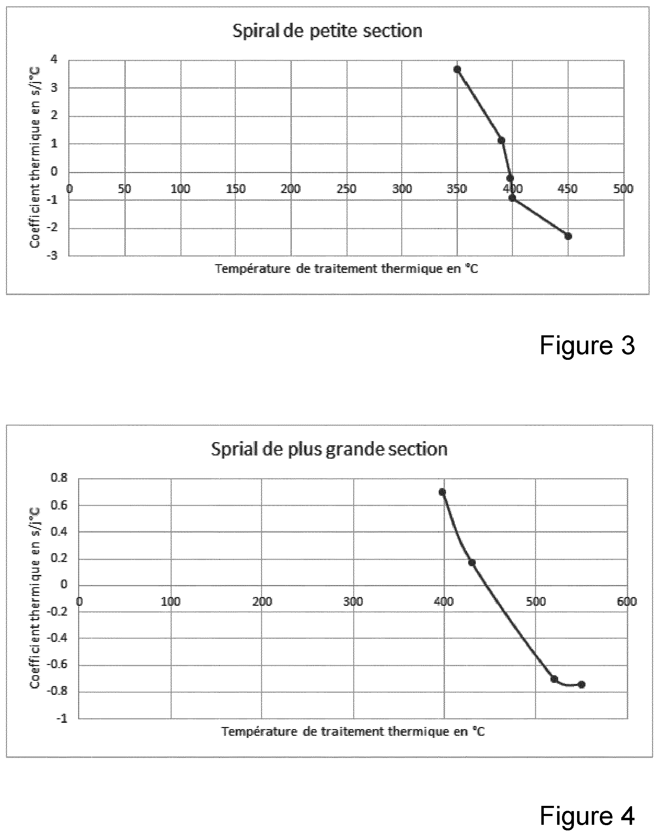

Des essais ont montré que le taux d'oxydation de la surface du spiral 1 réduit le CTE et augmente le module de Young. Les résultats de deux essais sont illustrés sur les figures 3 et 4.

Dans chaque cas, un spiral en alliage NbTi47 (c'est-à-dire en alliage binaire comprenant substantiellement 53% par poids de niobium et substantiellement 47% par poids de titane) a été fabriqué selon le procédé de la figure 1a, et a été appairé avec un balancier conventionnel en alliage cuivre-béryllium, dont l'inertie augmente légèrement lorsque la température augmente. Cet ensemble balancier-spiral a été monté dans un mouvement conventionnel à échappement à ancre suisse afin d'effectuer des essais de la marche de l'oscillateur en fonction du taux d'oxydation de la surface.

Le spiral 1 utilisé lors des essais de la figure 3 présente une épaisseur E de 0,023mm, une hauteur H de 0,117mm ainsi qu'une longueur L de 85mm, l'oscillateur ayant été réglé pour battre à une fréquence de 28'800 alternances par heure. Celui de la figure 4 présente une épaisseur E de 0,036mm, une hauteur H de 0,161mm ainsi qu'une longueur L de 134mm, cet oscillateur ayant été réglé pour battre à une fréquence de 21'600 alternances par heure.

Le taux d'oxydation de la surface, et ainsi sa profondeur P, a été varié en effectuant l'étape d de la procédure à des températures différentes pendant une durée de 2 heures sous une atmosphère d'air ambiante à une pression de 10⁻³ mbar. Le réglage de l'oscillateur par le biais de la définition du point de pitonnage ainsi que par une raquetterie conventionnelle compense les variations du module de Young engendrées par les différents traitements thermiques afin d'isoler l'effet sur le CTE. La marche du mouvement a été mesurée de manière conventionnelle à plusieurs températures (notamment à 8°C, 23°C et 38°C) afin de générer les résultats rapportés.

Les résultats sont les suivants :
Spiral de la figure 3 :

| Température de traitement thermique (étape d), °C | Coefficient thermique de la marche en s/j°C |
|---|---|
| 350 | +3.8 |
| 375 | +1.2 |
| 390 | -0.2 |
| 400 | -0.9 |
| 450 | -2.2 |

Spiral de la figure 4 :

| Température de traitement thermique (étape d), °C | Coefficient thermique de la marche en s/j°C |
|---|---|
| 400 | +0.7 |
| 430 | +0.18 |
| 520 | -0.7 |
| 550 | -0.75 |

D'après ces résultats, il est clair que le coefficient thermique de la marche de l'oscillateur diminue lorsque le taux d'oxydation de la surface du spiral 1 augmente, et que l'effet est plus prononcé pour le spiral 1 de la figure 3 qui présente les plus petites dimensions. Il est ainsi clair que l'effet de l'oxydation sur le spiral 1 est un effet de surface, le rapport périmètre/section étant plus élevé pour le spiral 1 de la figure 3 que pour celui de la figure 4, qui engendre un effet plus prononcé à une température de traitement moins élevée pour ce premier par rapport à ce dernier.

En effet, pour rendre les oscillateurs testés entièrement thermocompensés, une température de traitement d'environ 390°C sous les autres conditions mentionnées est approprié pour le spiral 1 de la figure 3, tandis que pour celui de la figure 4, la température correspondante est environ 450 °C. Pour le surplus, la variation en marche en fonction de la température du traitement thermique est plus prononcée pour le spiral 1 de la figure 3 (variation de +3.8 à -2.2 s/j°C entre 350°C et 450°C) que pour celui de la figure 4 (de +0.7 à - 0.75 s/j°C entre 400 et 550 °C).

Il est noté qu'une augmentation de la marche (c'est-à-dire une avance) lorsque la température augmente (coefficient thermique de la marche positif) correspond à une augmentation de la raideur (et donc du module de Young) du spiral 1 lorsque la température augmente, tandis qu'une diminution de la marche (c'est à dire un retard) lorsque la température augmente (coefficient thermique de la marche négatif) correspond à une diminution de la raideur du spiral 1 lorsque la température augmente (ou bien d'une thermocompensation incomplète de l'effet de la température sur l'inertie d'un balancier conventionnel, qui entraine un retard), en tenant compte en tout cas de la réponse thermique du balancier. Par conséquent, il est clair que la couche d'oxyde présente un CTE qui est fortement négatif, qui permet de compenser le CTE positif de l'alliage.

Au vu de ce qui précède, il est clair que la variation en module de Young du spiral 1 en fonction de la température peut être manipulée en variant le taux d'oxydation de sa surface dans l'étape d de la procédure. Ce faisant, le CTE positif de l'alliage du spiral 1 peut être choisi entre certaines bornes afin de le compenser, et par conséquent de compenser la réponse thermique du balancier au moins partiellement.

Par exemple, dans le cas classique d'un balancier dont l'inertie augmente lorsque la température monte, cela tend à réduire la fréquence d'oscillation, un CTE légèrement positif du spiral tend à augmenter la fréquence d'oscillation (diminuant ainsi la marche) et peut compenser au moins partiellement l'effet de la dilatation du balancier, donnant une variation de marche en fonction de la température de proche de zéro.

Dans le cas d'un balancier, dont l'inertie diminue lorsque la température monte, un CTE négatif (ralentissant la marche) le compensera.

Bien entendu, le coefficient thermique de la marche peut être choisi à volonté, la thermocompensation du spiral 1 étant par conséquent partielle, substantiellement exacte ou représentant une surcompensation.

Le même effet est obtenu pour les alliages niobium-zirconium et niobium-hafnium.

Bien que l'invention ait été précédemment décrite en lien avec des modes de réalisations spécifiques, d'autres variantes supplémentaires sont également envisageables sans sortir de la portée de l'invention comme définie par les revendications.

## Revendications

1. Procédé de fabrication d'un ressort spiral (1) pour oscillateur balancier-spiral, comprenant les étapes de :
a) se munir d'une lame (3) en alliage Niobium-Titane, Niobium-Zirconium ou Niobium-Hafnium présentant une hauteur (H) et une épaisseur (E) prédéterminées ;
b) effectuer un estrapadage de ladite lame (3) afin de mettre ladite lame (3) en forme de spiral (1) ;
c) effectuer un traitement thermique de fixation afin de figer la forme de ladite lame (3) ;
d) effectuer une oxydation de la surface de ladite lame (3) jusqu'à une profondeur (P) prédéterminée,
**caractérisé en ce que** lesdites étapes sont effectuées selon la suite a), d), b), c).

2. Procédé selon la revendication 1, dans lequel ladite lame (3) est obtenue par laminage d'un fil tréfilé dudit alliage, une étape de coupe des lacets étant effectué avant l'étape d) ou entre l'étape d) et l'étape b).

3. Procédé selon l'une des revendications précédentes, dans lequel l'étape d) est effectuée en chauffant ladite lame (3) sous les conditions suivantes :
- température entre 350°C et 700°C, de préférence entre 400°C et 600°C, encore de préférence entre 400°C et 450°C ;
- sous atmosphère oxydante à une pression entre 10⁻⁴ mbar à 10⁻² mbar, de préférence entre 10^{-3.5} mbar et 10^{-2.5} mbar et/ou à une pression partielle d'oxygène entre 0,2x10⁻⁴ mbar et 0,2x10⁻² mbar, de préférence entre 0,2x10^{-3.5} mbar et 0,2x10^{-2.5} mbar ;
- durée comprise entre 1h et 20h, de préférence entre 2h et 14h.

4. Procédé selon la revendication précédente, dans lequel ladite atmosphère oxydante est de l'air ou l'oxygène.

5. Procédé selon l'une des revendications 3 ou 4, dans lequel ledit chauffage est effectué dans un four et/ou est obtenu par l'effet Joule.

6. Procédé selon l'une des revendications 1 ou 2, dans lequel l'étape d) comporte une anodisation.

7. Procédé selon l'une des revendications précédentes, dans lequel ledit traitement thermique de fixation est effectué sous les conditions suivantes :
- pression entre 10⁻⁹ mbar et 10⁻⁵ mbar, de préférence entre 10⁻⁷ mbar et 10⁻⁶ mbar, et/ou sous atmosphère inerte ;
- température entre 400°C et 700°C ;
- durée entre 1h et 6h.

8. Procédé selon l'une des revendications précédentes, dans lequel ledit alliage est un alliage binaire Niobium-Titane présentant entre 40% et 60% par poids de titane, de préférence entre 45% et 55% par poids de titane, encore de préférence entre 46% et 48% par poids de titane.

## Patentansprüche

1. Verfahren zur Herstellung einer Spiralfeder (1) für einen Unruh-Spiral-Oszillator, umfassend den Schritten :
a) Bereitstellen einer Klinge (3) aus einer Niob-Titan-, Niob-Zirkon- oder Niob-Hafnium-Legierung mit einer vorbestimmten Höhe (H) und Dicke (E) ;
b) Durchführen eines Aufwindens der Klinge (3), um die Klinge (3) in die Form einer Spirale (1) zu bringen ;
c) Durchführen einer Fixierungswärmebehandlung, um die Form der Klinge (3) zu verfestigen
d) Durchführen einer Oxidation der Oberfläche der Klinge (3) bis zu einer vorbestimmten Tiefe (P),
**dadurch gekennzeichnet, dass** die Schritte gemäß der Reihenfolge a), d), b), c) durchgeführt werden.

2. Verfahren nach Anspruch 1, wobei die Klinge (3) durch Walzung eines gezogenen Drahtes der Legierung beschaffen wird, wobei ein Schritt zum Schneiden der Endstücke vor Schritt d) oder zwischen Schritt d) und Schritt b) durchgeführt wird.

3. Verfahren nach einem der vorhergehenden Ansprüche, wobei der Schritt d) durch Erhitzen der Klinge (3) unter den folgenden Bedingungen durchgeführt wird:
- Temperatur zwischen 350°C und 700°C, vorzugsweise zwischen 400°C und 600°C, weiter bevorzugt zwischen 400°C und 450°C ;
- in oxidierender Atmosphäre bei einem Druck zwischen 10⁻⁴ mbar und 10⁻² mbar, vorzugsweise zwischen 10^{-3.5} mbar und 10^{-2.5} mbar und/oder bei einem Sauerstoffpartialdruck zwischen 0,2x10⁻⁴ mbar und 0,2x10⁻² mbar, vorzugsweise zwischen 0,2x10^{-3.5} mbar und 0,2x10^{-2.5} mbar ;
- Dauer zwischen 1 h und 20 h, vorzugsweise zwischen 2 h und 14 h.

4. Verfahren nach dem vorhergehenden Anspruch, wobei die oxidierende Atmosphäre Luft oder Sauerstoff ist.

5. Verfahren nach einem der Ansprüche 3 oder 4, wobei das Erhitzen in einem Ofen erfolgt und/oder durch den Joule-Effekt erreicht wird.

6. Verfahren nach einem der Ansprüche 1 oder 2, wobei Schritt d) eine Anodisierung umfasst.

7. Verfahren nach einem der vorhergehenden Ansprüche, wobei die Wärmebehandlung zur Fixierung unter folgenden Bedingungen durchgeführt wird:
- Druck zwischen 10-9 mbar und 10-5 mbar, vorzugsweise zwischen 10-7 mbar und 10-6 mbar, und/oder unter Inertgasatmosphäre ;
- Temperatur zwischen 400°C und 700°C ;
- Dauer zwischen 1h und 6h.

8. Verfahren nach einem der vorhergehenden Ansprüche, wobei die Legierung eine binäre Niobium-Titan-Legierung ist, die zwischen 40 und 60 Gew.-% Titan, vorzugsweise zwischen 45 und 55 Gew.-% Titan, noch bevorzugter zwischen 46 und 48 Gew.-% Titan aufweist.

## Claims

1. Method of manufacturing a balance spring (1) for a balance-hairspring oscillator, comprising the steps of :
a) providing a Niobium-Titanium, Niobium-Zirconium or Niobium-Hafnium alloy blade (3) having a predetermined height (H) and thickness (E);
b) winding-in said blade (3) to shape said blade (3) into a spiral shape (1);
c) heat treatment to fix the shape of said blade (3);
d) oxidizing the surface of said blade (3) to a predetermined depth (P),
**characterized in that** said steps are carried out in sequence a), d), b), c).

2. Method according to claim 1, wherein said blade (3) is obtained by rolling a drawn wire of said alloy, a tip cutting step being performed prior to step d) or between step d) and step b).

3. Method according to one of the preceding claims, wherein step d) is carried out by heating said blade (3) under the following conditions :
- temperature between 350°C and 700°C, preferably between 400°C and 600°C, even more preferably between 400°C and 450°C ;
- in an oxidizing atmosphere at a pressure of between 10⁻⁴ mbar and 10⁻² mbar, preferably between 10^{-3.5} mbar and 10^{-2.5} mbar and/or at an oxygen partial pressure of between 0.2x10⁻⁴ mbar and 0.2x10⁻² mbar, preferably between 0.2x10^{-3.5} mbar and 0.2x10^{-2.5} mbar ;
- duration between 1h and 20h, preferably between 2h and 14h.

4. Method according to the preceding claim, wherein said oxidizing atmosphere is air or oxygen.

5. Method according to one of claims 3 or 4, wherein said heating is carried out in a furnace and/or is obtained by the Joule effect.

6. Method according to one of claims 1 or 2, wherein step d) comprises an anodisation.

7. Method according to one of the preceding claims, wherein said fixing heat treatment is carried out under the following conditions :
- pressure between 10⁻⁹ mbar and 10⁻⁵ mbar, preferably between 10⁻⁷ mbar and 10⁻⁶ mbar, and/or under inert atmosphere ;
- temperature between 400°C and 700°C;
- time between 1h and 6h.

8. Method according to one of the preceding claims, wherein said alloy is a binary Niobium-Titanium alloy having between 40% and 60% by weight of titanium, preferably between 45% and 55% by weight of titanium, even more preferably between 46% and 48% by weight of titanium.
